(19) Europäisches Patentamt
European Patent Office
Office européen des brevets

(11) **EP 2 118 944 B1**

(12) **EUROPÄISCHE PATENTSCHRIFT**

(45) Veröffentlichungstag und Bekanntmachung des Hinweises auf die Patenterteilung:
**13.06.2018 Patentblatt 2018/24**

(21) Anmeldenummer: **08706862.3**

(22) Anmeldetag: **01.02.2008**

(51) Int Cl.:
**H01L 51/52** *(2006.01)*

(86) Internationale Anmeldenummer:
**PCT/DE2008/000197**

(87) Internationale Veröffentlichungsnummer:
**WO 2008/098551 (21.08.2008 Gazette 2008/34)**

(54) **ELEKTROLUMINESZENTES ORGANISCHES HALBLEITERELEMENT**

ELECTROLUMINESCENT ORGANIC SEMICONDUCTOR ELEMENT

ÉLÉMENT SEMI-CONDUCTEUR ORGANIQUE ÉLECTROLUMINESCENT

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **16.02.2007 DE 102007007853**

(43) Veröffentlichungstag der Anmeldung:
**18.11.2009 Patentblatt 2009/47**

(73) Patentinhaber: **OSRAM OLED GmbH**
**93049 Regensburg (DE)**

(72) Erfinder:
- **KLEIN, Markus**
  **93105 Tegernheim (DE)**
- **SCHLENKER, Tilman**
  **93152 Nittendorf (DE)**

(74) Vertreter: **Epping - Hermann - Fischer Patentanwaltsgesellschaft mbH Schloßschmidstraße 5 80639 München (DE)**

(56) Entgegenhaltungen:
EP-A- 1 505 664     WO-A-97/32452
WO-A-98/06122     WO-A-2007/004118
JP-A- 5 114 487     JP-A- 9 162 440
US-A- 5 719 467     US-A- 5 723 873
US-A1- 2003 219 923

- **GUSTAFSSON G: "FLEXIBLE LIGHT-EMITTING DIODES MADE FROM SOLUBLE CONDUCTING POLYMERS" NATURE, NATURE PUBLISHING GROUP, LONDON, Bd. 357, 11. Juni 1992 (1992-06-11), Seiten 477-479, XP002127850 ISSN: 0028-0836**
- **KIJIMA Y ET AL: "A BLUE ORGANIC LIGHT EMITTING DIODE" JAPANESE JOURNAL OF APPLIED PHYSICS, JAPAN SOCIETY OF APPLIED PHYSICS, TOKYO, JP, Bd. 38, Nr. 9A, PART 01, 1. September 1999 (1999-09-01), Seiten 5274-5277, XP000947550 ISSN: 0021-4922**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein elektrolumineszentes organisches Halbleiterleiterelement.

Diese Patentanmeldung beansprucht die Priorität der deutschen Patentanmeldung 10 2007 007 853.8, deren Offenbarungsgehalt hiermit durch Rückbezug aufgenommen wird.

Die Druckschrift D1 (EP 1505664 A2) beschreibt eine transparente Elektrode für elektro-optische Aufbauten.

Elektrolumineszente organische Halbleiter, auch als so genannte OLEDs bezeichnet werden heutzutage hauptsächlich für Flachbildschirme eingesetzt. Sie gewinnen aber auch im Hinblick auf normale Lichtanwendungen zunehmend an Bedeutung, da sie eine hohe Leuchtkraft bei gleichzeitig geringem Stromverbrauch aufweisen. Im Allgemeinen umfasst ein elektrolumineszenter organischer Halbleiter ein Substrat, auf dem zwischen zwei Elektroden ein lichtemittierendes organisches Material angeordnet ist. Die Elektroden, sehr häufig aus einem Metall oder einem Metalloxid wie beispielsweise Indium-dotiertes Zinnoxid (ITO) oder Indium-dotiertes Zinkoxid (IZO) gefertigt, dienen dazu, die bei der Rekombination lichterzeugenden Ladungsträger möglichst flächig auf dem organischen Material zu verteilen. Durch die großflächige Verteilung wird eine verbesserte Lichtausbeute erreicht. Dabei werden von der Kathode Elektronen in das organische Material initiiert, die Anode stellt die notwendigen positiven Ladungsträger in Form von Löchern bereit.

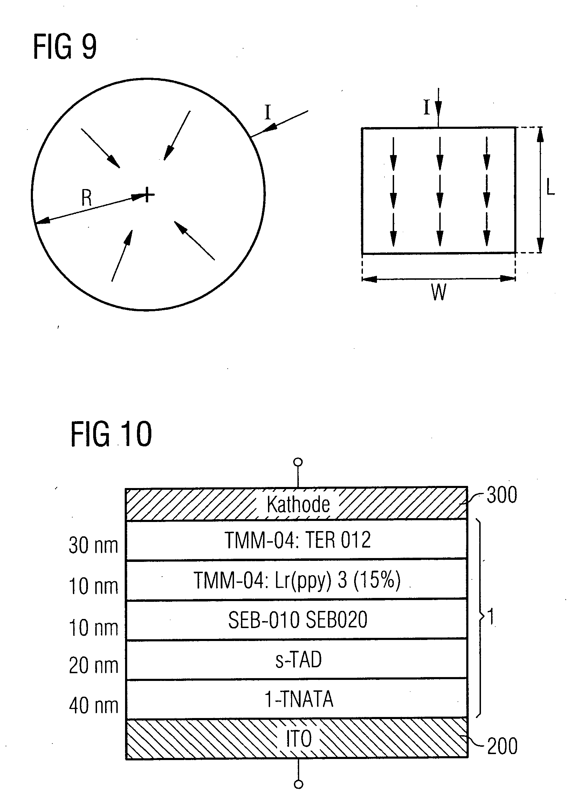

Das organische Material umfasst typischerweise mehrere Schichtfolgen, die verschiedene Aufgaben übernehmen. Figur 10 zeigt eine derartige typische Struktur zweier Elektroden, 200 und 300 sowie den dazwischen angeordneten "OLED-Stack" aus H.Becker et. al SID Digest (2005). Durch die einzelnen Schichtfolgen, deren Dicken beispielhaft in Figur 10 dargestellt sind, werden die Elektronen beziehungsweise Löcher zu der für die Photonengeneration bestimmte Schicht transportiert. Dies sind vorliegend die drei obersten Schichten des Stacks, der zumindest eine organische Schicht 1 umfasst. Gleichzeitig dienen die unteren Schichtenfolgen zu einer Begrenzung einer Exzitonendiffusion beziehungsweise blocken einen ungewünschten Löcher- beziehungsweise Elektronentransport. Beispielsweise dienen die Schichten S-TAD und 1-TNATA als Lochtransporter bzw. Elektronenblocker. Dadurch werden Löcher beziehungsweise Elektronen in der für die Rekombination vorgesehenen Schicht gehalten, wodurch die Rekombinationseffizienz und damit die Lichtausbeute erhöht wird. Das durch die Ladungsträgerrekombination erzeugte Licht kann grundsätzlich durch die Kathode beziehungsweise die Anode oder auch durch beide ausgekoppelt werden.

Ein wesentlicher Gesichtspunkt in der Anwendung von organischen Leuchtdioden als Lichtquelle besteht in den notwendigen Kosten pro Flächeneinheit.

Durch die heute verwendeten Anoden aus Indium-dotiertem Zinnoxid beziehungsweise dotiertem Zinkoxid und den Kathoden aus einer leitfähigen Schicht werden durch die benötigten Lithografieprozesse beachtliche Kosten verursacht. Insbesondere die Herstellung großflächiger Lichtquellen führte somit zu einem erhöhten Kostenaufwand. Darüber hinaus kann es zu Schwierigkeiten bei der Realisierung transparenter Elektroden führen, welche beispielsweise für die so genannten Top-Emitter notwendig sind. Dabei ist die oberste Schicht für das durch die Ladungsträgerrekombination erzeugte Licht transparent. Hierbei kommen vor allem transparente, leitfähige Oxide, wie beispielsweise Antimonzinnoxid oder Indiumzinnoxid, als auch dünne Metallelektroden zum Einsatz. Abhängig von den verwendeten Kathodenmaterialien ist auch hier der Herstellungsprozess einer optischen Leuchtdiode mit hohen Kosten verbunden. Zusätzlich ist oftmals die Leitfähigkeit der Elektrode problematisch, wodurch die Lichtausbeute reduziert wird.

Es besteht demnach das Bedürfnis, elektrolumineszente organische Halbleiter vorzusehen, mit denen einerseits die Lichtausbeute verbessert und andererseits die Herstellungskosten reduziert werden können. Eine weitere Aufgabe ist es, ein Verfahren vorzusehen, bei dem Fertigungstoleranzen beziehungsweise schadhafte Stellen in einer organischen Leuchtdiode ohne größere Einschränkungen hinsichtlich der Lichtausbeute repariert werden können.

Diese Aufgabe wird mit dem Gegenstand des unabhängigen Patentanspruchs 1 gelöst. Weiterbildungen und Ausgestaltungen der Erfindung ergeben sich aus den Unteransprüchen.

Bei der Erfindung ist vorgesehen, in einem elektrolumineszenten organischen Halbleiterelement wenigstens eine der beiden Elektroden, zwischen denen die organische Schichtfolge angeordnet ist durch eine hoch leitfähige organische Schicht zu ersetzen. Damit können viele Probleme insbesondere bei der Herstellung der Leuchtdioden umgangen werden.

Entsprechend umfasst ein erfindungsgemäßes elektrolumineszentes organisches Halbleiterelement ein Substrat, eine erste über dem Substrat angeordnete Elektrode, eine zweite Elektrode sowie eine organische Schichtfolge die zwischen der ersten und der zweiten Elektrode angeordnet ist und dabei eine durch Ladungsträgerrekombination lichterzeugende Schicht umfasst. Die erste und zweite Elektrode enthält jeweils eine hoch leitfähige organische Teilschicht. Die hoch leitfähige organische Teilschicht übernimmt erfindungsgemäß die flächige, laterale Verteilung der zugeführten Ladungsträger und ist somit ein wesentlicher Bestandteil der Elektrode.

Durch die Verwendung einer hoch leitfähigen organischen Teilschicht können die Probleme bei den Herstellungsprozessen reduziert werden, die sich aufgrund der bislang verwendeten leitfähigen Oxide beziehungsweise Metallelektroden ergeben. So kann mit Vorteil die hoch leitfähige organische Teilschicht für das durch Ladungsträgerrekombination erzeugte Licht zumindest teilweise transparent sein. Dadurch ergibt sich eine einfache und kosteneffiziente Herstellung organischer Leuchtdioden mit zumindest teilweise transparenter Elektrode. Zusätzlich können beide Elektroden mit hoch leitfähigen organischen Teilschichten realisiert werden. Es lässt sich so besonders einfach ein zumindest teilweise transparentes Bauteil entwickeln.

In einer Ausgestaltung der Erfindung kann die hoch leitfähige organische Teilschicht ein Material aus der Stoffklasse der so genannten "small molecules", der Polymere oder einer anderen organischen Klasse umfassen. Dies können beispielsweise PEDOT:PSS (poly(3,4-ethylendioxythiophene):poly(styrene sulfonat))-Verbindungen sein. Als dotiertes Polymer eignet sich insbesondere dotiertes Polyanilin, Polypyrrol, Polythiophen. Ebenso möglich sind PANI:PSS Materialien oder andere Stoffe aus der Klasse der Polystyrole wie beispielsweise Polystyrol-Natriumsulfonat. Umfasst die hoch leitfähige organische Teilschicht Materialien aus der Klasse der "small molecules", können diese unter anderem dotierte Systeme wie beispielsweise ZnPC (Zink-Phtalocyanin) mit einem Benzolderivat sein, der als Elektronendonator oder -Akzeptor fungiert (TCNQ). Andere Beispiele umfassen ein Metalloxid mit einem Ladungstransferkomplex, beispielsweise MeO-TPD/F4-TCNQ oder BEDT-TTF (Tetrathiavulvalen) Materialien, der einen organischer Supraleiter darstellt.

Ebenso ist es möglich, dass die hoch leitfähige organische Teilschicht ein mit einem Metall, organischem oder rein anorganische Salz dotiertes Polymer aufweist. Durch die Verwendung einer metallischen Dotierung lässt sich die Leitfähigkeit und auch die Art des Ladungstyps verbessern. Spezielle n- beziehungsweise p-Leitung können so realisiert werden. In einer Weiterbildung der Erfindung kann eine Metallisierungsschicht zwischen der ersten Elektrode und dem Substrat beziehungsweise auf der zweiten Elektrode aufgebracht sein. Dadurch wird die laterale Leitfähigkeit der Elektroden weiter verbessert und die Lichtausbeute erhöht.

In einem anderen Aspekt der Erfindung umfasst die wenigstens eine erste Elektrode eine zweite leitfähige Teilschicht. Diese weist bezüglich der hoch leitfähigen organischen Teilschicht eine unterschiedliche Leitfähigkeit auf. Durch zusätzliche leitfähige vorzugsweise organische Teilschichten kann eine Anpassung der hoch leitfähigen organischen Teilschicht an die organische Schichtfolge durchgeführt werden, in welcher die Ladungsträgerrekombination erfolgt. Beispielsweise Herstellungsprozesse lassen sich somit vereinfachen. In einer anderen möglichen Ausgestaltung der Erfindung umfasst die leitfähige Teilschicht ein dotiertes organisches Material. Dieses kann zwischen der hoch leitfähigen organischen Teilschicht und der organischen Schichtfolge angeordnet sein. Zudem kann es zweckmäßig sein, wenn diese zweite leitfähige Teilschicht einen Leitungstyp aufweist, der unterschiedlich zu einem Leitungstyp der hoch leitfähigen organischen Teilschicht ist.

Damit können beispielsweise hoch leitfähige organische Teilschichten für Elektroden verwendet und diese an die organische Schichtfolge angepasst werden. Ebenso ist es möglich, dass die zweite leitfähige Teilschicht ein anorganisches Material, beispielsweise ein Metall umfasst.

In einer anderen Weiterbildung der Erfindung ist eine metallische Buselektrode vorgesehen, die auf der hoch leitfähigen organischen Teilschicht und damit auf der wenigstens einen Elektrode aufgebracht ist. Die metallische Buselektrode dient vorteilhaft zu einer Verringerung des Flächenwiderstands und damit einer Reduzierung des lateralen Spannungsabfalls durch den Widerstand der Elektroden. Die laterale Stromverteilung wird weiter verbessert.

In einer Ausgestaltung der Erfindung kann die zweite Elektrode eine hoch leitfähige organische Teilschicht umfassen, auf der zusätzlich eine metallische Buselektrode aufgebracht ist. Die metallischen Buselektroden können eine Vielzahl im Wesentlichen parallel verlaufende Leitungsabschnitte aufweisen. Bei einer Verwendung zweier Elektroden mit jeweils einer hoch leitfähigen organischen Teilschicht ist besonders eine alternierende, das heißt abwechselnde Struktur der Buselektroden zweckmäßig. Dadurch kann mit Vorteil die gleiche Weglänge auf verschiedenen Strompfaden durch die organische Leuchtdiode erreicht werden. Ein lateraler Spannungsabfall über eine nicht ideal leitfähige Schicht wird teilweise kompensiert.

In einer anderen Ausgestaltung der Erfindung umfasst die metallische Buselektrode eine Vielzahl von Leitungsabschnitten, die zu einer wabenförmigen Struktur miteinander elektrisch leitend verbunden sind. Eine derartige Struktur führt zu einer verbesserten lateralen Stromverteilung durch die organische hochleitfähige Elektrode und damit zu einer höheren Lichtausbeutung bei gleichem Stromverbrauch. In einer weiteren Ausgestaltung der Erfindung weist die erste und die zweite Elektrode einen im Wesentlichen gleichen Flächenwiderstand auf.

Das hier dargestellte elektrolumineszente organische Halbleiterelement, bei der wenigstens eine Elektrode eine metallische Buselektrode zur Verbesserung eines lateralen Spannungsabfalls aufweist, besitzt sehr einfache Reparaturmöglichkeiten. In einem erfindungsgemäßen Verfahren zur Reparatur eines elektrolumineszenten organischen Halbleiterelementes wird in einem ersten Schritt die schadhafte Stelle in einer organischen Schicht des Halbleiterelementes erfasst. Dieses kann unter anderem durch visuelle Inspektion des elektrolumineszenten organischen Halbleiterelementes erfolgen. Ist eine derartige schadhafte Stelle in einer organischen Schicht ermittelt, werden Leiterabschnitte der Buselektroden erfasst, welche im Bereich der ermittelten schadhaften Stelle liegen. Sodann werden diese erfassten Leiterabschnitte zur Erhöhung des Spannungsabfalls im Bereich der schadhaften Stelle in der organischen Schicht selektiv zerstört.

Bei einer nicht fehlerfrei produzierten Lichtquelle kann die schadhafte Stelle einen lokalen Kurzschluss verursachen, der zu einer Beschädigung des elektrolumineszenten organischen Halbleiterelements führt. Durch das selektive Zerstören von Leiterabschnitten von Buselektroden im Bereich der ermittelten schadhaften Stelle wird der Spannungsabfall in der betroffenen organischen Schicht erhöht. Dadurch wird ein zusätzliches Widerstandselement erzeugt, wodurch der durch die schadhafte Stelle verursachte lokale Kurzschluss keine schädlichen Auswirkungen auf das organische Halbleiterelement besitzt. Auf die Gesamtleistung des Lichtelementes besitzt das erfindungsgemäße Verfahren dennoch keinen Einfluss, sofern das Verhältnis der aktiven zu der abgeschnittenen Fläche groß genug bleibt.

Für das selektive Zerstören eignet sich insbesondere ein laserstrahlinduziertes Durchtrennen der erfassten Leiterabschnitte der Buselektroden.

Im Folgenden wird die Erfindung unter Zuhilfenahme der Zeichnungen anhand mehrerer Ausführungsbeispiele im Detail erläutert.

Es zeigen:

Figur 1    ein erstes Ausführungsbeispiel der Erfindung,

Figur 2    ein zweites Ausführungsbeispiel der Erfindung mit mehreren Teilschichten der Elektroden,

Figur 3    ein Ausführungsbeispiel der Erfindung zur Darstellung gleicher Weglänge in verschiedenen Strompfaden,

Figur 4    ein viertes Ausführungsbeispiel der Erfindung,

Figur 5    ein fünftes Ausführungsbeispiel der Erfindung,

Figur 6    ein sechstes Ausführungsbeispiel der Erfindung,

Figur 7    zwei Ausführungsbeispiele für verschiedene Buselektrodenstrukturen,

Figur 8    zwei weitere Ausführungsbeispiele für Buselektrodenstrukturen,

Figur 9    eine Darstellung zur Verdeutlichung des Strompfades zum Abschätzen des lateralen Widerstandes,

Figur 10   eine Darstellung eines Aufbaus eines bekannten organischen Halbleiterelements.

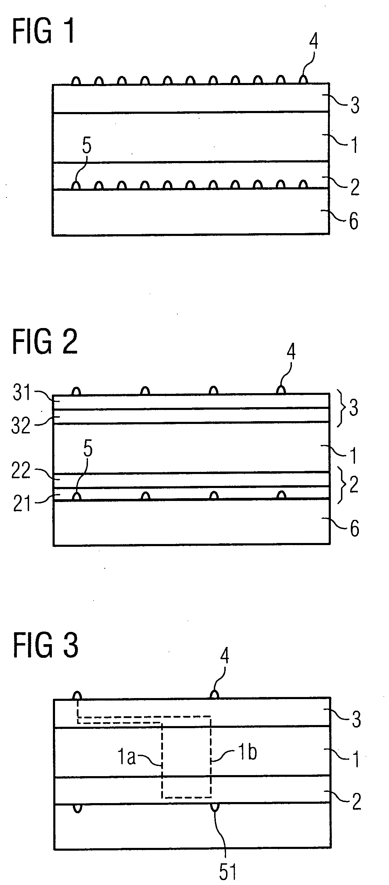

Figur 1 zeigt ein elektrolumineszentes organischen Halbleiterelementes, auch organische Leuchtdiode genannt, mit Elektrodenstrukturen, welche aus einem hoch leitfähigen organischen Material gebildet sind.

Die organische Leuchtdiode ist dabei auf einem Substrat 6 aufgebracht. Dieses Substrat 6 kann beispielsweise als transparentes Material Glas oder auch ein transparentes nicht leitendes organisches Polymer umfassen. Auf dem Substrat 6 ist eine erste Elektrode 2, die eine organische hoch leitfähige Schicht umfasst, aufgebracht. Diese dient der lateralen Verteilung der Ladungsträger zur vertikalen Injektion in die darüber aufgebaute Schichtfolge. Weiterhin umfasst die erste Elektrode 2 zusätzliche, in einer Struktur angeordneten Buselektroden 5, welche eine Vielzahl parallel angeordneter, metallischer Leiterabschnitte enthalten. Durch die zusätzlichen Leiterabschnitte werden gerade bei großen Bauteilen eine verbesserte laterale Verteilung der Ladungsträger und damit des Stroms erreicht. Das Aufbringen hoch leitfähiger metallischer Materialien wird als Shunting bezeichnet und kann beispielsweise durch ij-Printen, Siebdruck oder Schattenmaskenaufdampfverfahren erfolgen.

Auf die erste Elektrode 2 mit der hoch leitfähigen organischen Schicht wird der eigentliche OLED-Stack mit der lichterzeugenden Teilschicht aufgebracht. Der einzelne OLED-Stack (OLED für organische Leuchtdiode) kann eine Vielzahl organischer Schichten 1 umfassen. Diese besitzen unterschiedliche Aufgaben beispielsweise der Injektion der Ladungsträger, des Ladungsträgertransports oder des Blockens von Elektronen beziehungsweise Löchern. Weiterhin sollen durch die mehreren organischen Schichten 1 die Exzitonendiffusion verringert beziehungsweise begrenzt werden. Innerhalb eines schmal umgrenzten Bereichs des OLED-Stacks findet die eigentliche Ladungsträgerrekombination statt. Dabei rekombinieren die von der Kathode eingeführten Elektroden mit den Löchern der Anode und führen zu einer Photonenregeneration. Durch zum Beispiel Aufbringen verschiedener Schichten, in denen Ladungsträger rekombinieren, können auch verschiedenfarbige Dioden hergestellt werden.

Auf den OLED-Stack ist als zweite Elektrode 3 eine weitere hoch leitfähige organische Schicht abgeschieden, die eine Anode sein kann. Diese kann zusätzlich weitere, in einer Struktur angeordneten Buselektroden 4 aus mehreren parallel angeordneten Leiterabschnitten enthalten. Die Elektroden können unterschiedliches Material aufweisen, was von besonderem Vorteil ist, da Löcher und Elektronen injiziert werden und diese sich anders verhalten. Somit werden gute Loch- bzw. Elektronenleiter ausgewählt.

Die in einer Struktur angeordneten Buselektroden 4 auf der Oberseite der zweiten Elektrode 3 können durch einfaches Aufdampfen, Aufdrucken oder ähnliche Maßnahmen appliziert werden. In gleicher Weise lässt sich auch die Struktur der Buselektroden 5 der ersten Elektrode 2 realisieren.

Zur Verbesserung der Anpassung der Schichten untereinander können zusätzliche organische und leitfähige Teilschichten innerhalb der Elektroden 2 und 3 vorgesehen sein.

Dies ist in Figur 2 gezeigt. Hierbei umfasst die erste Elektrode 2 eine erste hochleitfähige organische Teilschicht 21 sowie eine zweite leitfähige Teilschicht 22. Die erste hochleitfähige organische Teilschicht 21 steht in elektrischer Verbindung zu den Buselektroden 5 der ersten Elektrode 2. Die zweite leitfähige Teilschicht 22, die organisch oder eine Metallisierungsschicht sein kann, dient zur Anpassung der Energieniveaus beziehungsweise der Prozessverträglichkeit an die unteren Schichten des OLED-Stacks oder der zumindest einen organischen Schicht 1. Eine derartige Ausgestaltung ist insbesondere dann zweckmäßig, wenn beispielsweise für die Herstellung der ersten Schicht des OLED-Stacks und der hochleitfähigen organischen Teilschicht 21 unterschiedliche Prozesse und Herstellungsverfahren benötigt werden. Auch kann die zweite leitfähige Teilschicht 22 dann zweckmäßig sein, sofern die organische hochleitfähige Teilschicht 21 und die organischen Schichten 1 des OLED-Stacks chemisch miteinander in unerwünschter Weise reagieren. In diesem Fall wirkt die zusätzliche zweite leitfähige Teilschicht 22 als Isolation bezüglich unerwünschter chemischer Reaktionen.

In gleicher Weise umfasst die zweite Elektrode 3 die hochleitfähige organische Teilschicht 31 auf der Oberseite sowie eine zweite leitfähige Teilschicht 32, die zwischen der hochleitfähigen organischen Teilschicht 31 und der zumindest einen organischen Schicht 1, beispielsweise einem OLED-Stack, angeordnet ist. Die zweite leitfähige Teilschicht 32 dient auch hier zur besseren Anpassung der hochleitfähigen organischen Teilschicht 31 an den OLED-Stack oder der zumindest einen organischen Schicht 1. Der OLED-Stack umfasst in dieser Ausgestaltung lediglich eine organische Schicht 1, in der die Photonengeneration durch Ladungsträgerrekombination stattfindet. Um hierzu eine möglichst hohe Rekombinationseffizienz und damit Lichtausbeute zu gewährleisten, werden die Elektroden 2 und 3 mit ihrem hochleitfähigen organischen Teilschichten 21 und 31 flächig auf dem OLED-Stack aufgebracht. Zur weiteren Verbesserung der lateralen Stromverteilung sind zusätzlich die Buselektroden 4 und 5 auf beiden Seiten der Elektroden 2 und 3 vorgesehen. Der maximal erlaubte Flächenwiderstand $R_{sqr}$ der organischen Elektroden 2 und 3 kann als Funktion der geometrischen Randbedingungen sowie der benötigten Stromdichte j abgeschätzt werden.

Figur 9 zeigt hierzu zwei schematische Darstellungen für ein kreisrundes sowie ein quadratisches elektrolumineszentes organisches Halbleiterelement. Das kreisrunde Halbleiterelement besitzt einen Radius von R, während das quadratische Element eine Länge L sowie eine Breite W aufweist. Das kreisrunde Halbleiterelement wird von außen mit einer Stromquelle verbunden zur Zuführung des Stroms I. Entsprechend ist das quadratische Halbleiterelement auf einer Seite mit einer Stromquelle verbunden. Die Zuführung an die Stromquelle weist jeweils eine unendliche Leitfähigkeit auf.

Ferner sei angenommen, dass die eigentliche Stromdichte j durch den OLED-Stack und damit die organische Schichtfolge oder die zumindest eine organische Schicht 1 hier senkrecht zur Zeichenfläche konstant in der Fläche ist. Der gesamte durch das elektrolumineszente organische Halbleiterelement fließende Strom I ergibt sich somit aus der Stromdichte j multipliziert mit der Fläche der Anordnung. Für das kreisrunde elektrolumineszente organische Halbleiterelement mit Radius R ergibt sich somit in erster Näherung ein maximaler lateraler Spannungsabfall $U_{max}$ über der Elektrode zu:

$$U_{\mathbf{max}} = \frac{1}{4\pi} R_{sqr} I = \frac{1}{4} R_{sqr} R^2 j$$

Im Fall der quadratischen Anordnung mit der Breite W und der Länge L ergibt sich für den maximalen lateralen Spannungsabfall $U_{max}$:

$$U_{\mathbf{max}} = \frac{L}{2W} R_{sqr} I = \frac{1}{2} R_{sqr} L^2 j$$

Für Lichtanwendungen steht die Lichtausbeute im Vordergrund. Diese kann typischerweise 100 cd/m$^2$ bis 5000 cd/m$^2$ betragen. Bei einer Lichtausbeute von 1000 cd/m$^2$ und einer angestrebten Effizienz von 50 cd/A ergibt sich eine Stromdichte von j = 20 A/m$^2$. Der maximale laterale Spannungsabfall sollte bei einer Betriebsspannung $U_B$ von circa $U_B$ = 5 V den Wert von $U_{max}$ = 100 mV nicht überschreiten. Daraus ergibt sich abhängig von dem Radius R = 1 mm ein Flächenwiderstand $R_{sqr}$ von kleiner als

$$R_{sqr} = \frac{4 U_{\mathbf{max}}}{R^2 j} = 80 k\Omega \; .$$

Bei dem quadratisch angeordneten Halbleiterelement und einer parallel verlaufenden Buselektrodenstruktur im Abstand von L = 0,5 mm folgt für den Widerstand $R_{sqr}$ gleich:

$$R_{sqr} = \frac{2 U_{\mathbf{max}}}{L^2 j} = 40 k\Omega$$

Für eine angenommene Schichtdicke der Elektroden von 100 nm bedeutet dies einen minimalen spezifischen Leitwert in [S] für die oben dargestellten geometrischen Randbedingungen von:

σ = 1,25 S/cm für das runde Element beziehungsweise

σ = 2,5 S/cm für das das quadratische Halbleiterelement.

Die dargestellte Leitfähigkeit kann mit organischen Leuchtdioden beispielsweise mit PEDOT mit Werten bis über $\sigma$ = 200 S/cm leicht erreicht werden. Zusätzlich kann zu einer Verbesserung der Leitfähigkeit die organische Teilschicht mit geeigneten Materialien dotiert werden. Auch die Klasse der "small molecules" als organische Teilschicht lässt sich hierzu einsetzten. Die so erreichte Leitfähigkeit der organischen Teilschicht steigt auf Werte, die einen flächigen Abschluss mit einer Metallelektrode und geeigneten Buselektrode unter geeigneten geometrischen Randbedingungen obsolet machen, wobei die Dotierung innerhalb der organischen Teilschicht einen ohmschen Kontakt mit dem Material der Buselektrode selbst herstellt.

Einen weiteren Aspekt betrifft die Ausgestaltung der Buselektroden innerhalb der Elektroden 2 beziehungsweise 3.

Figur 3 zeigt, dass die Buselektroden 51 der ersten Elektrode 2 auf der Elektrode 2 und damit in das Substrat 6 eingebracht sind. Dies kann beispielsweise dadurch erreicht werden, dass auf das Substrat 6, das ein Glassubstrat sein kann, selektiv Leiterbahnen beziehungsweise Leiterabschnitte appliziert werden. Anschließend werden darauf die erste Elektrode 2 mit der hochleitfähigen organischen Teilschicht abgeschieden. Dann wird der OLED-Stack hergestellt und die zweite Elektrode 3 aufgebracht. Die Buselektroden 4 sind derart auf der zweiten Elektrode 3 aufgebracht, dass sie bezüglich der Buselektroden 51 alternierend angeordnet sind. Dies hat den Vorteil, dass verschiedene Strompfade 1a, 1b bei einer nicht ideal leitfähigen Schicht in Summe immer die gleichen Weglängen ergeben. Dadurch werden laterale Spannungsabfälle über die nicht ideal leitfähige Schicht teilweise kompensiert.

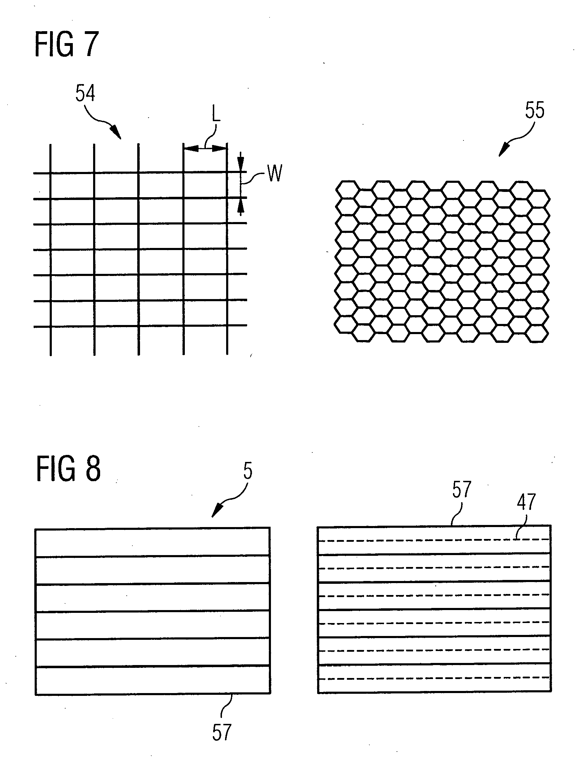

Figur 8 zeigt eine Draufsicht auf diese Strukturen der Buselektroden der entsprechenden Elektroden. Hierbei sind die einzelnen Leiterabschnitte 57 im Wesentlichen parallel zueinander angeordnet. In der linken Abbildung sind beide Strukturen der Buselektroden 5 und 4 übereinander angeordnet. In der rechten Abbildung erfolgt eine alternierende Realisierung der Strukturen der Buselektroden 5 beziehungsweise 4, so dass abwechselnd in der dargestellten Draufsicht ein Leiterabschnitt 57 der Struktur der Buselektroden 5 benachbart zu einem Leiterabschnitt 47 der Struktur der Buselektroden 4 befindet.

Andere Ausgestaltungsmöglichkeiten für Busstrukturen zeigt Figur 7. Hierbei können zum einen die Busstrukturen in Form von Quadraten beziehungsweise Rechtecken also mit senkrecht zueinander verlaufenden Leiterabschnitten ausgebildet sein (Bustruktur 54). Eine alternative Busstruktur 55 zeigt die rechte Darstellung in Form einer wabenförmigen Ausbildung.

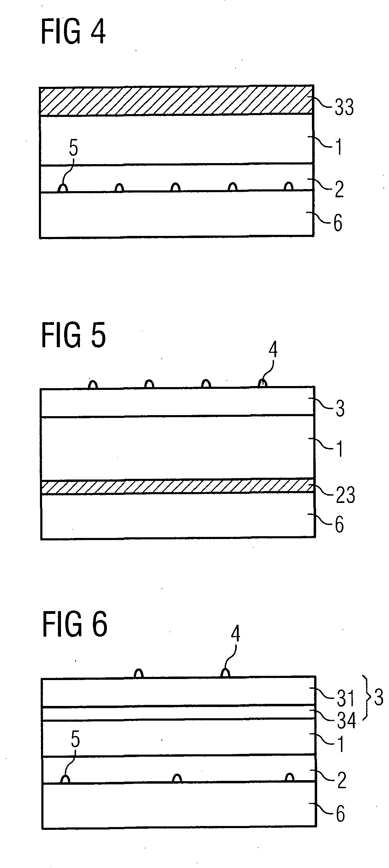

Abhängig von der Applikation kann es sinnvoll sein, organische Leuchtdioden herzustellen, die Licht nur einseitig auskoppeln. Eine derartige Ausgestaltung zeigt Figur 4. Bei dieser umfasst die zweite Elektrode 33 eine Metallschicht in Form einer planaren Elektrode, welches eine reflektierende Oberfläche bezüglich des in der organischen Schicht 1 erzeugten Lichts aufweist. Entsprechend werden die durch die Ladungsträgerrekombination erzeugten Photonen von der verspiegelten Oberfläche der zweiten Elektrode 33 reflektiert und durch die erste Elektrode 2 und das Substrat 6, das ein Glassubstrat sein kann, ausgekoppelt. Die erste Elektrode 2 mit der hochleitfähigen Schicht kann zusätzlich ebenso ein Metall oder auch ein leitfähiges Metalloxid umfassen.

Figur 5 zeigt eine ähnliche Ausgestaltung, bei der die erste Elektrode 2 durch eine anorganische Schicht 23 ersetzt ist. Diese anorganische Schicht 23, welche die Anode darstellt kann beispielsweise Indiumdotiertes Zinkoxid sein. Ebenso ist es möglich, eine reine metallische Schicht als Ersatz für die erste Elektrode 2 zu verwenden. Das Licht wird in diesem Fall durch die zweite Elektrode 3 ausgekoppelt. Die in der Figur 5 dargestellte Ausführungsform entspricht somit einem so genannten Top-Emitter.

Figur 6 zeigt, dass die zweite Elektrode 3 eine erste hochleitfähige organische Teilschicht 31 sowie eine zweite leitfähige Teilschicht 34 aufweist. Die hochleitfähige organische Teilschicht 31 kann das gleiche Material wie die erste Elektrode 2 enthalten. Da über die erste und die zweite Elektrode 2 und 3 Ladungsträger unterschiedlichen Leitungstyps in den OLED-Stack oder die zumindest eine organische Schicht 1 injiziert werden, kann dies dazu führen, dass bei der Verwendung gleichen Materials für die hochleitfähige organische Teilschicht 31 und die erste Elektrode 2 eine zusätzliche Anpassung an den OLED-Stack erfolgen muss. In der hier dargestellten Ausführungsform enthält die hochleitfähige organische Teilschicht 31 beziehungsweise die erste Elektrode 2 das Material PEDOT:PSS. Dieses Material ist als so genannter Lochleiter bezeichnet. Da in der zweiten Elektrode 3, die eine Kathode umfassen kann, Lochelektronen als Ladungsträger injiziert werden, ist eine zusätzliche Anpassung an die obere Schicht des OLED-Stacks erforderlich. Hierzu dient die zweite leitfähige Schicht 34, die vorliegend zusätzlich n-dotiert ist. Dadurch kann das hochleitfähige organische System der Teilschicht 31 an den OLED-Stack angepasst werden.

Durch die dotierte zweite leitfähige Teilschicht 34 ist somit ein guter ohmscher Kontakt zu Materialien möglich, die eigentlich von der Lage des Energieniveaus her keinen geeigneten Kontakt für die Injektion der Ladungsträger erlauben. Entsprechend ist es ebenso denkbar, die zweite leitfähige Teilschicht 34 auch zwischen der ersten Elektrode 2 und dem OLED-Stack oder der zumindest einen organischen Schicht 1 vorzusehen. Alternativ kann anstatt der organischen zweiten leitfähigen Teilschicht 34 auch eine zusätzliche anorganische Schicht verwendet werden. Diese sorgt dann für eine Anpassung der zumindest einen organischen Schicht 1 an die organische Elektrode, sofern dies beispielsweise für die Prozessverträglichkeit notwendig ist.

Ebenso kann eine zusätzliche anorganische Teilschicht verwendet werden, um die Ladungsträgerinjektion in den OLED-Stack zu verbessern. Dies ist sinnvoll, wenn die anorganische Teilschicht als solche eine deutlich schlechtere Leitfähigkeit als das hoch leitfähige organische Material aufweist und somit als alleinige Elektrode ungeeignet wäre. Durch die zusätzliche hochleitfähige organische Teilschicht 31 ist jedoch auch hier eine gute laterale Verteilung der Ladungsträger erreichbar.

Die hier dargestellten Ausführungsformen mit den Elektroden aus hoch leitfähigen organischen Schichten können auf verschiedene Weise hergestellt werden.

Zum einen bietet es sich an, lösungsmittelbasierte Herstellungsverfahren wie beispielsweise Schleudern, Sprühen oder Drucken zu verwenden. Beim Sprühen sowie beim Drucken kann zusätzlich eine Maske beziehungsweise eine Sieb für eine Strukturierung der jeweiligen Schichten verwendet werden. Eine Strukturierung der Schicht lässt sich beim Schleudern durch ein lokales Vernetzen der Schicht und Abwaschen der nicht vernetzten Bereiche erzielen. Ein Vernetzen beispielsweise mit organischen Polymeren bietet darüber hinaus die Möglichkeit mehrschichtig lösungsmittelbasierte Schichten aufzubringen, ohne dass sich beim Aufbringen einer Schicht die vorangegangene wieder löst.

Zum anderen besteht die Möglichkeit, organische Materialien durch Aufdampfen oder OVPD-Verfahren anzufertigen. Bei einer Co-Evaporation von Dotierstoffen können ebenfalls besonders leitfähige organische Lagen realisiert werden.

Die Benutzung zusätzlicher Buselektrodenstrukturen bietet zudem eine einfachere Reparaturmöglichkeit nicht fehlerfrei produzierter Lichtquellen. Mithilfe einer Reparatur kann die Ausbeute an hergestellten Lichtquellen erhöht werden.

Während der Herstellung kann es beim Aufbringen der einzelnen organischen Schichten zu einem lokalen Kurzschluss beispielsweise durch leitende Schmutzpartikel oder andere Verunreinigungen kommen. Dieser lokale Kurzschluss führt häufig innerhalb des elektrolumineszenten organischen Halbleiterelementes zu einem erhöhten Stromfluss und damit einer thermischen Aufheizung an dieser Stelle. Durch die thermische Aufheizung wird gegebenenfalls die organische Schicht beschädigt und die Lichtausbeute sinkt. Für eine Reparatur wird nunmehr die schadhafte Stelle, beispielsweise durch visuelle Inspektion des Halbleiterelementes ermittelt.

Dann werden die in der Nähe der schadhaften Stelle befindlichen Buselektroden erfasst und selektiv mittels Durchtrennung der Leiterabschnitte zerstört. Dadurch wird der Spannungsabfall in der betroffenen organischen Schicht, der nunmehr über eine längere Strecke stattfinden muss erhöht. Der lokale Kurzschluss innerhalb der organischen Schicht verursacht durch den zusätzlich eingebrachten vorgeschalteten Widerstand keinen Schaden mehr im Halbleiterelement. Auf die Gesamtleistung des Lichtelementes hat ein selektives Durchtrennen von Leiterabschnitten kaum Einfluss, sofern das Verhältnis der aktiven Fläche des Halbleierelementes zu der abgeschnittenen Fläche groß genug bleibt. Insbesondere die in Figur 7 gezeigten Elektrodenstrukturen eignen sich hierzu, da aus dem Netzwerk lokale Bereich herausgetrennt werden können, ohne die großflächige Leitfähigkeit der Buselektrodenstruktur zu beeinflussen.

**Patentansprüche**

1. Elektrolumineszentes organisches Halbleiterelement, umfassend:

   - ein Substrat (6);
   - eine erste über dem Substrat (6) angeordnete Elektrode (2) ;
   - eine zweite Elektrode (3);
   - mindestens eine organische Schicht (1), die zwischen erster Elektrode (2) und der zweiten Elektrode (3) angeordnet ist und eine durch Ladungsträgerrekombination Licht erzeugende Schicht umfasst;
   wobei die erste und die zweite Elektrode (2, 3) jeweils eine hochleitfähige organische Teilschicht (21, 31) umfasst, wobei die hochleitfähige organische Teilschicht (21, 31) der wenigstens einen Elektrode eine Leitfähigkeit größer als 0,1 S/cm aufweist,
   wobei zumindest eine der Elektroden weiterhin eine zweite leitfähige Teilschicht (34, 32, 22) umfasst, welche bezüglich der hochleitfähigen organischen Teilschicht (21, 31) eine unterschiedliche Leitfähigkeit aufweist,
   wobei die zweite leitfähige Teilschicht (34, 32) ein dotiertes organisches Material oder ein anorganisches Material umfasst.

2. Das Halbleiterelement nach Anspruch 1, bei dem die erste Elektrode (2) oder die zweite Elektrode (3) zu einer flächigen Zuführung von Ladungsträgern unterschiedlichen Typs an die organische Schicht (1) ausgebildet sind.

3. Das Halbleiterelement nach einem der Ansprüche 1 bis 2, bei dem die wenigstens eine hochleitfähige organische Teilschicht (21, 31) zumindest eines der folgenden Materialien umfasst:

   - Polymere;
   - small molecules;
   - dotierte Polymere;
   - dotierte small molecules;
   - PEDOT:PSS;
   - PANI:PSS;
   - ZnPc/F4-TCNQ;
   - MeO-TPD/F4-TCNQ;
   - BEDT-TTF.

**4.** Das Halbleiterelement nach einem der Ansprüche 1 bis 3, bei dem die wenigstens eine hochleitfähige organische Teilschicht (21, 31) ein mit einem Metall oder einem organischen Salz oder einem anorganischen Salz dotiertes Polymer oder dotiertes small molecule aufweist.

**5.** Das Halbleiterelement nach einem der Ansprüche 1 bis 4, weiter umfassend:

> - eine zweite leitfähige Teilschicht (22), die eine Metallisierungsschicht umfasst und die zwischen der hochleitfähigen organischen Teilschicht (21) und dem Substrat (6) oder auf der zweiten Elektrode (3) aufgebracht ist.

**6.** Das Halbleiterelement nach einem der Ansprüche 1 bis 5, bei dem die zweite Elektrode (3) oder das Substrat (6) und die erste Elektrode (2) für eine Wellenlänge des durch die zumindest eine organische Schicht (1) erzeugten Lichts zumindest teilweise transparent sind.

**7.** Das Halbleiterelement nach Anspruch 1, bei dem die hochleitfähige organische Teilschicht (21, 31) einen ersten Leitungstyp und die zweite leitfähige Teilschicht (34) einen zweiten Leitungstyp aufweist, der von dem ersten Leitungstyp unterschiedlich ist.

**8.** Das Halbleiterelement nach Anspruch 1 oder 7, bei dem die zweite leitfähige Teilschicht (22, 32, 34) zwischen der hochleitfähigen organischen Teilschicht (31, 21) und der zumindest einen organischen Schicht (1) angeordnet ist.

**9.** Das Halbleiterelement nach einem der Ansprüche 1 bis 8, bei dem die wenigstens eine Elektrode eine hochleitfähige Buselektrode (5, 4), aufweist, die auf die hochleitfähige organische Teilschicht (21, 31) aufgebracht ist.

**10.** Das Halbleiterelement nach einem der Ansprüche 1 bis 9, bei dem die erste und die zweite Elektrode (2, 3) jeweils eine hochleitfähige organische Teilschicht (21, 31) aufweisen, auf der jeweils eine metallische Buselektrode (5, 4) aufgebracht ist.

**11.** Das Halbleiterelement nach einem der Ansprüche 9 bis 10, bei dem die metallische Buselektrode (5, 4) eine Vielzahl parallel über die hochleitfähige organische Teilschicht (21, 31) verlaufende Leiterabschnitte (47, 57) aufweist, dem die metallische Buselektrode (5, 4) eine Vielzahl von Leitungsabschnitten aufweist, die zu einer wabenförmigen Struktur miteinander elektrisch leitend verbunden sind oder bei dem die parallel verlaufenden Leiterabschnitte (57) der wenigstens einen Elektrode bezüglich der parallel verlaufenden Leiterabschnitte (47) der anderen Elektrode alternierend angeordnet sind.

**12.** Das Halbleiterelement nach einem der Ansprüche 1 bis 11, bei dem die erste und die zweite Elektrode den gleichen Flächenwiderstand aufweisen.

**Claims**

**1.** An electroluminescent organic semiconductor element comprising:

> - a substrate (6);
> - a first electrode (2) arranged above the substrate (6);
> - a second electrode (3);
> - at least one organic layer (1) arranged between the first electrode (2) and the second electrode (3) and comprising a layer generating light by carrier recombination;

the first and second electrodes (2, 3) each comprising a highly conductive organic sublayer (21, 31), the highly conductive organic sublayer (21, 31) of the at least one electrode having a conductivity greater than 0.1 S/cm, at least one of the electrodes further comprising a second conductive sublayer (34, 32, 22) which has a different conductivity with respect to the highly conductive organic sublayer (21, 31), wherein the second conductive sublayer (34, 32) comprises a doped organic material or an inorganic material.

**2.** The semiconductor element according to claim 1, in which the first electrode (2) or the second electrode (3) are formed to a planar supply of charge carriers of different types to the organic layer (1).

**3.** The semiconductor element according to one of claims 1 to 2, wherein the at least one highly conductive organic sublayer (21, 31) comprises at least one of the following materials:

> - polymers;
> - small molecules;
> - doped polymers;
> - doped small molecules;
> - PEDOT:PSS;
> - PANI:PSS;
> - ZnPc/F4-TCNQ;
> - MeO-TPD/F4-TCNQ;
> - BEDT-TTF.

**4.** The semiconductor element according to one of claims 1 to 3, wherein the at least one highly conductive organic sublayer (21, 31) comprises a polymer or small molecule doped with a metal or an organic salt or an inorganic salt.

5. The semiconductor element according to one of claims 1 to 4 further comprising:

- a second conductive sublayer (22) comprising a metallisation layer and being applied between the highly conductive organic sublayer (21) and the substrate (6) or on the second electrode (3).

6. The semiconductor element according to one of claims 1 to 5, wherein the second electrode (3) or the substrate (6) and the first electrode (2) are at least partially transparent to a wavelength of light produced by the at least one organic layer (1).

7. The semiconductor element according to claim 1, wherein the highly conductive organic sublayer (21, 31) has a first charge type and the second conductive sublayer (34) has a second charge type different from the first charge type.

8. The semiconductor element according to one of claims 1 or 7, wherein the second conductive sublayer (22, 32, 34) is disposed between the highly conductive organic sublayer (31, 21) and the at least one organic layer (1).

9. The semiconductor element according to one of claims 1 to 8, in which the at least one electrode has a highly conductive bus electrode (5, 4) which is applied to the highly conductive organic sublayer (21, 31).

10. The semiconductor element according to one of claims 1 to 9, at in which the first and the second electrodes (2, 3) each have a highly conductive organic sublayer (21, 31) on which respectively a metallic bus electrode (5, 4) is applied.

11. The semiconductor element according to one of claims 9 to 10, in which the metallic bus electrode (5, 4) has a plurality of conductor sections (47, 57) running in parallel over the highly conductive organic sublayer (21, 31), in which the metallic bus electrode (5, 4) has a plurality of conductor sections which are electrically conductively connected to one another in form of a honeycomb-shaped structure or in which the conductor sections (57) running in parallel of the at least one electrode are arranged alternately with respect to the parallel conductor sections (47) of the other electrode.

12. The semiconductor element according to one of claims 1 to 11, in which the first and second electrodes have the same sheet resistance.

**Revendications**

1. Élément semi-conducteur organique électroluminescent, comprenant :

- un substrat (6) ;
- une première électrode (2) disposée au-dessus du substrat (6) ;
- une deuxième électrode (3) ;
- au moins une couche organique (1) qui est disposée entre la première électrode (2) et la deuxième électrode (3) et comprend une couche générant de la lumière par recombinaison de porteurs de charge ;
la première et la deuxième électrodes (2, 3) comprenant respectivement une couche partielle (21, 31) organique à haute conductivité, la couche partielle (21, 31) organique à haute conductivité de l'au moins une électrode présentant une conductivité supérieure à 0,1 S/cm,
au moins une des électrodes comprenant en outre une deuxième couche partielle (34, 32, 22) conductrice, laquelle, par rapport à la couche partielle (21, 31) organique à haute conductivité, présente une conductivité différente,
la deuxième couche partielle (34, 32) conductrice comprenant une matière organique dopée ou une matière anorganique.

2. Élément semi-conducteur selon la revendication 1, dans lequel la première électrode (2) ou la deuxième électrode (3) sont conçues pour amener de manière plane à la couche organique (1) des porteurs de charge de type différent.

3. Élément semi-conducteur selon l'une quelconque des revendications 1 à 2, dans lequel l'au moins une couche partielle (21, 31) organique à haute conductivité comprend au moins une des matières suivantes :

- polymères ;
- petites molécules ;
- polymères dopés ;
- petites molécules dopées ;
- PEDOT : PSS ;
- PANI : PSS ;
- ZnPc/F4-TCNQ ;
- MeO-TPD/F4-TCNQ ;
- BEDT-TTF.

4. Élément semi-conducteur selon l'une quelconque des revendications 1 à 3, dans lequel l'au moins une couche partielle (21, 31) organique à haute conductivité présente un polymère dopé ou une petite molécule dopée avec un métal ou un sel organique ou un sel anorganique.

**5.** Élément semi-conducteur selon l'une quelconque des revendications 1 à 4, comprenant en outre :

- une deuxième couche partielle (22) conductrice qui comprend une couche de métallisation et qui est appliquée entre la couche partielle (21) organique à haute conductivité et le substrat (6) ou sur la deuxième électrode (3).

**6.** Élément semi-conducteur selon l'une quelconque des revendications 1 à 5, dans lequel la deuxième électrode (3) ou le substrat (6) et la première électrode (2) sont transparents au moins en partie pour une longueur d'onde de la lumière générée par l'au moins une couche organique (1).

**7.** Élément semi-conducteur selon la revendication 1, dans lequel la couche partielle (21, 31) organique à haute conductivité présente un premier type de conductivité et dans lequel la deuxième couche partielle (34) conductrice présente un deuxième type de conductivité qui est différent du premier type de conductivité.

**8.** Élément semi-conducteur selon la revendication 1 ou 7, dans lequel la deuxième couche partielle (22, 32, 34) conductrice est disposée entre la couche partielle (31, 21) organique à haute conductivité et l'au moins une couche organique (1).

**9.** Élément semi-conducteur selon l'une quelconque des revendications 1 à 8, dans lequel l'au moins une électrode présente une électrode de bus (5, 4) à haute conductivité, qui est placée sur la couche partielle (21, 31) organique à haute conductivité.

**10.** Élément semi-conducteur selon l'une quelconque des revendications 1 à 9, dans lequel la première et la deuxième électrodes (2, 3) présentent respectivement une couche partielle (21, 31) organique à haute conductivité, sur laquelle est respectivement placée une électrode de bus (5, 4) métallique.

**11.** Élément semi-conducteur selon l'une quelconque des revendications 9 à 10, dans lequel l'électrode de bus (5, 4) métallique présente une pluralité de sections de conducteur (47, 57) s'étendant parallèlement au-dessus de la couche partielle (21, 31) organique à haute conductivité, dans lequel l'électrode de bus (5, 4) métallique présente une pluralité de sections de ligne qui sont reliées entre elles de manière électroconductrice en une structure en nid d'abeille ou dans lequel les sections de conducteur (57), s'étendant parallèlement, de l'au moins une électrode sont disposées de manière alternante par rapport aux sections de conducteur (47), s'étendant parallèlement, de l'autre électrode.

**12.** Élément semi-conducteur selon l'une quelconque des revendications 1 à 11, dans lequel la première et la deuxième électrodes présentent la même résistance de surface.

## FIG 1

## FIG 2

## FIG 3

FIG 4

FIG 5

FIG 6

## FIG 7

54

L

W

55

## FIG 8

5

57

47

57

# FIG 9

# FIG 10

| | |
|---|---|
| | Kathode — 300 |
| 30 nm | TMM-04: TER 012 |
| 10 nm | TMM-04: Lr(ppy) 3 (15%) |
| 10 nm | SEB-010 SEB020 |
| 20 nm | s-TAD |
| 40 nm | 1-TNATA |
| | ITO — 200 |

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102007007853
- EP 1505664 A2

**In der Beschreibung aufgeführte Nicht-Patentliteratur**

- **H.BECKER.** OLED-Stack. *SID Digest,* 2005